# EUROPEAN PATENT SPECIFICATION

(11) **EP 2 818 456 B1**
(45) Date of publication and mention of the grant of the patent: **24.04.2019**
(21) Application number: 13194658.4
(22) Date of filing: 27.11.2013
(51) Int. Cl.: C30B 21/00

(54) **Metal-dielectric eutectic material for use in plasmonics**
Metallisches dielektrische eutektisches Material zur Verwendung in der Plasmonik
Matériau eutectique métallique-diélectrique destiné à être utilisé en plasmonique

(30) Priority: 27.06.2013 PL 40447513
(43) Date of publication of application: 31.12.2014
(73) Proprietor: Instytut Technologii Materialów Elektronicznych, 01-919 Warszawa (PL)
(72) Inventor: Sadecka, Katarzyna, 04-163 Warszawa (PL); Gajc, Marcin, 03-316 Warszawa (PL); Pawlak, Dorota, 01-835 Warszawa (PL); Klos, Andrzej, 00-019 Warszawa (PL)
(74) Representative: AOMB Polska Sp. z.o.o.

(56) References cited:
- EP-A1- 2 639 343
- W. L. BARNES ET AL.: "Surface plasmon subwavelength optics", NATURE, vol. 424, no. 6950, 14 August 2003 (2003-08-14), pages 824-830, XP007901985, DOI: i:10.1038/nature01937
- T. TRUPKE ET AL.: "Improving solar cell efficiencies by up-conversion of sub-band-gap light", J. APPL. PHYS., vol. 92, no. 7, 1 October 2002 (2002-10-01), pages 4117-4122, XP002725295, DOI: 10.1063/1.1505677
- T. SOM; B. KARMAKAR: "Nanosilver enhanced upconversion fluorescence of erbium ions in Er 3 + : Agantimonyglass nanocomposites", J. APPL. PHYS., vol. 105, no. 1, 1 January 2009 (2009-01-01), pages 013102-1-013102-8, XP002725296, DOI: 10.1063/1.3054918
- C. STROHHOFER; A. POLMAN: "Silver as a sensitizer for erbium", APPL. PHYS. LETT., vol. 81, no. 8, 19 August 2002 (2002-08-19), pages 1414-1416, XP002725297, DOI: 10.1063/1.1499509
- C. ROCKSTUHL ET AL.: "Design of an Artificial Three-Dimensional Composite Metamaterial with Magnetic Resonances in the Visible Range of the Electromagnetic Spectrum", PHYS. REV. LETT., vol. 99, no. 1, 5 July 2007 (2007-07-05), pages 017401-1-017401-4, XP002725298, DOI: 10.1103/PhysRevLett.99.017401
- N. LIU ET AL.: "Three-dimensional photonic metamaterials at optical frequencies", NAT. MATER., vol. 7, no. 1, July 2008 (2008-07), pages 31-37, XP002725299, DOI: 10.1038/nmat2072
- Katarzyna Sadecka, Marcin Gajc, Andrzej Klos, _Barbara Surma, Dorota A. Pawlak: "Self-organized metallodielectric eutectic nanopartie based composite material: manufacturing and properties", Institute of Electronic Materials Technology ( ITME ), Warszawa 01919, Poland On-line Journal of 17th International Conference on Crystal Growth and Epitaxy- ICCGE-17,, 22 May 2013 (2013-05-22), XP002725778, Poster at 17th International Conference on Crystal Growth and Epitaxy - ICCGE-17, Topical Session 9, by Katarzyna Sadecka Retrieved from the Internet: URL:http://science24.com/paper30140 [retrieved on 2013-05-22]

## Description

The object of the invention is an eutectic material, in particular a metal-dielectric one. The invention is applicable in plasmonics which is based on the use of oscillation of free media in metallic structures in interactions with an electromagnetic wave.

Metal-dielectric composites consisting of a dielectric matrix with metallic nanostructures or of a metallic matrix with dielectric nanostructures are characterised by plasmonic properties due to the presence of localised surface plasmons, i.e. oscillation of free media in nanometric objects with a negative value of actual electric permittivity.

From the publication of W. L. Barnes et al., Nature 2003, 424, 824, a phenomenon of interaction of nanostructures with an electromagnetic wave of a frequency equal to the frequency of free media oscillation is known, the said phenomenon leading to the occurrence of localised surface plasmon resonance (LSPR). The resonance is affected by various factors, such as: size, shape, material of which the nanostructure is composed, as well as medium in which it is located.

The LSPR phenomenon is accompanied by the effect of strengthening of electromagnetic field around the nanostructure and by the increase in absorption and in scattering of the resonance wave. These effects reinforce various optical phenomena. Thus, for example from the publications of T. Trupke et al., J. Appl. Phys., 2002, 92, 4117, S. Kim et al., Nature, 2008, 7, 453, E.C. Le Ru, P.G. Etchegoin, "Principles of Surface Enhanced Raman Spectroscopy and Related Plasmonic Effects"; Elsevier: Amsterdam, 2009, and T. Som and B. Karmakar, J. Appl. Phys., 2009, 105, 013102, strengthening of the photoluminescence, of nonlinear properties, such as two-photon absorption, second-harmonic generation, Kerr effect, as well as strengthening of the surface enhanced raman spectroscopy and upconversion are known.

From the publication of N. Liu et al., Nat. Mater., 2008, 7, 31, obtaining of plasmonic materials by slow and complicated methods, such as ion-beam or electron beam lithography, is known. These methods do not provide for use on an industrial scale. Alternative methods, allowing rapid generation of plasmonic materials, are based mainly on the mechanism of chemical self-assembly. They include methods for obtaining metal-dielectric materials, such as a method by doping dielectric matrices with metal nanoparticles, known from the publication of C. Strohhöfer and A. Polman, Appl. Phys. Lett., 2002, 81, 1414, a method by forming aggregates of metal nanoparticles in colloidal solutions, known from the publication of C. Rockstuhl et al., Phys. Rev. Lett., 2007, 99, 017401, as well as a method using organic compounds, known from the publication of S. Vignolini et al., Adv. Mater., 2012, 24, 23. However, as their result, two-dimensional composites of relatively small dimensions and of low mechanical and chemical durability are obtained.

Chemical self-assembly mechanism is also present in the process of directional crystallisation of metal-dielectric eutectic mixtures which lead to self-ordering of their structure at the micro/nano level. The eutectic is a mixture of two or more phases of a defined chemical composition, which exhibits a lower melting point than the constituent phases.

From the publication of D. A. Pawlak, Scientia Plena, 2008, 4, 014801 and D.A. Pawlak, in: Eds.: T. Fukuda, V. I. Chani, Shaped Crystals, "Growth by Micro-Pulling-Down Technique", Springer, 2007, 129, eutectics obtained as a solid from a liquid/melt by cooling a temperature specified below, referred to as eutectic temperature, are known. However, the eutectic materials known so far do not have metallic phase of size smaller than 500 nm, enabling the use of resonance effects originating from the localised surface plasmons in the visible range.

Various methods for obtaining metal-dielectric materials with the use of eutectic crystallisation are known. From the publication of D.A. Pawlak et al., Chem. Mat., 2006, 18, 2450; D. A. Pawlak et al., Adv. Funct. Mat, 2010, 20(7) 1116 and K. Bieńkowski et al. "Cryst. Growth & Design", 2011, 11, 9, 3935, a method of removing one of the oxide-oxide eutectic phases, matrix or precipitates, and then filling the etched space with metal by dusting or in electrochemical process - for example Tb₃Sc₂Al₃O₁₂-TbScO₃, is known. However, when using this method, there are problems with obtaining precipitations of size required for using them in plasmonics, in particular in the optical range.

From the publication of R. I. Merino, et al., Recent Res. Devel. Mat. Sci, 2003, 4, 1, a method consisting in NiO-ZrO₂ eutectic growth, with a NiO metal oxide phase, which is subsequently reduced to Ni base metal, is known. This eutectic is not applicable in the plasmonic optical range because nickel metallic phase is characterised by a size larger than 500 nm.

From the publication of Final Technical Report No. E-18-610-1, "Investigation of the growth of directionally solidified eutectics with potential as electron emitters", Project Director: James F. Benzel, Principal Investigators: A.T. Chapman and J.K. Cochran, JPL Contract No. 954193 (1976), a method for obtaining, from a melt, metal-dielectric materials, such as ZrO₂-W, Cr₂O₃-Mo, HfO₂-W eutectics, is known. However, these materials have high melting points, and also they consist of metals with high optical losses, which exclude their use in plasmonics.

The EP2639343A1 publication discloses a method of manufacturing thin-film eutectic metal-dielectric films through directional crystallization where the directionally grown structures comprise preferably made of silicon, quartz, SiC or refractory ceramic material, most preferably of Al2O3 or ZrO2 type. This method leads to obtaining layered eutectic composites, metal-dielectric and dielectric-dielectric structures in the form of thin films. The process is carried out on flat plates and allows to achieve flat crystallization fronts at a relatively large area. The metal/metal oxide phase of the eutectic layer is in the form of submicron-sized structures e.g. lamellas or triangles.

There is still need for the development of the eutectic material which would consist of metallic nano-particles giving rise to localised surface plasmon resonance.

Other documents constituting the prior art for this invention are:
[1] W. L. BARNES ET AL., "Surface plasmon subwavelength optics", NATURE, (20030814), vol. 424, no. 6950, doi:i:10.1038/nature01937, pages 824 - 830;
[2] T. TRUPKE ET AL., "Improving solar cell efficiencies by up-conversion of subband-gap light", J. APPL. PHYS., (20021001), vol. 92, no. 7, doi:10.1063/1.1505677, pages 4117 - 4122
[3] T. SOM; B. KARMAKAR, "Nanosilver enhanced upconversion fluor;escence of erbium ions in Er 3 + : Agantimonyglass nanocomposites", J. APPL. PHYS., (20090101), vol. 105, no. 1, doi:10.1063/1.3054918, pages 013102-1 - 013102-8;
[4] C. STROHHOFER; A. POLMAN, "Silver as a sensitizer for erbium", APPL. PHYS. LETT., (20020819), vol. 81, no. 8, doi:10.1063/1.1499509, pages 1414 - 1416;
[5] C. ROCKSTUHL ET AL., "Design of an Artificial Three-Dimensional Composite Metamaterial with Magnetic Resonances in the Visible Range of the Electromagnetic Spectrum", PHYS. REV. LETT., (20070705), vol. 99, no. 1, doi:10.1103/PhysRevLett.99.017401, pages 017401-1 - 017401-4;
[6] N. LIU ET AL., "Three-dimensional photonic metamaterials at optical frequencies", NAT. MATER., (200807), vol. 7, no. 1, doi:10.1038/nmat2072, pages 31 - 37;
[7] Katarzyna Sadecka, Marcin Gajc, Andrzej Klos, _Barbara Surma, Dorota A. Pawlak, "Self-organized metallodielectric eutectic nanoparticles based composite material: manufacturing and properties", On-line Journal of 17th International Conference on Crystal Growth and Epitaxy- ICCGE-17" Poster at 17th International Conference on Crystal Growth and Epitaxy - ICCGE-17, Topical Session 9, by Katarzyna Sadecka, (20130522), Institute of Electronic Materials Technology (ITME), Warszawa 01919, Poland, URL: http://science24.com/paper30140, (20130522).

Contrary to the known materials, the material according to the invention meets all the requirements enabling the use in plasmonics, in particular in the visible light range.

An eutectic material according to the invention is characterised in that it consists of:
82.0 - 86.0 mole% of Bi₂O₃,
- constituting a dielectric matrix,
- having a positive actual electric permittivity, Re(eps) > 0 for the range of electromagnetic wavelengths λ UV/Vis/NIR,
and 14.0 - 18.0 mole% of Ag:
- constituting metallic precipitations of size not larger than 500 nm for use in the optical range,
- having a resistance of 15.87 nΩm,
- having a negative actual value of electric permittivity, Re(eps) < 0 for the range of electromagnetic wavelengths λ 172 nm - 258 nm and Re(eps) < 0 for the range of electromagnetic wavelengths λ from 326 nm to 2500nm,
- and of an imaginary value of electric permittivity Im(eps) for these ranges λ, respectively 1.79 - 3.6 F/m and from 0.579 F/m, proportionally increasing along with the wavelength λ.

Preferably, the material consists of 15.4 mole% of Ag of Re(esp) < 0 and of 84.6 mole% of Bi₂O₃ of Re(esp) >0.

The material according to the invention is applicable, according to need, in various forms of rods, straps or layers, or adequately prepared portions thereof.

### Brief Description of the Drawings

The example provided below illustrates the material according to the invention in its particular embodiment, without limiting its scope of application, based on a drawing, in which:

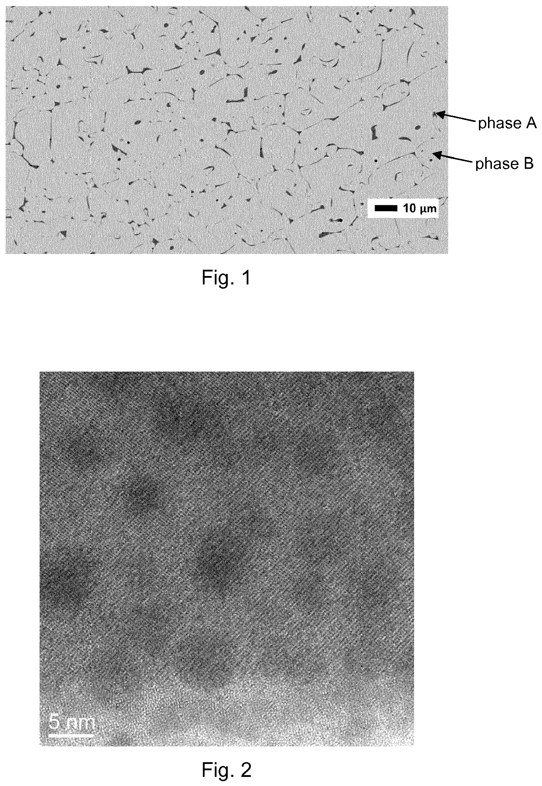

Fig. 1 shows a picture, from a scanning electron microscope, of a cross-section of Bi₂O₃ - Ag eutectic rod before annealing;
fig. 2 shows a picture from a transmission electron microscope after annealing;

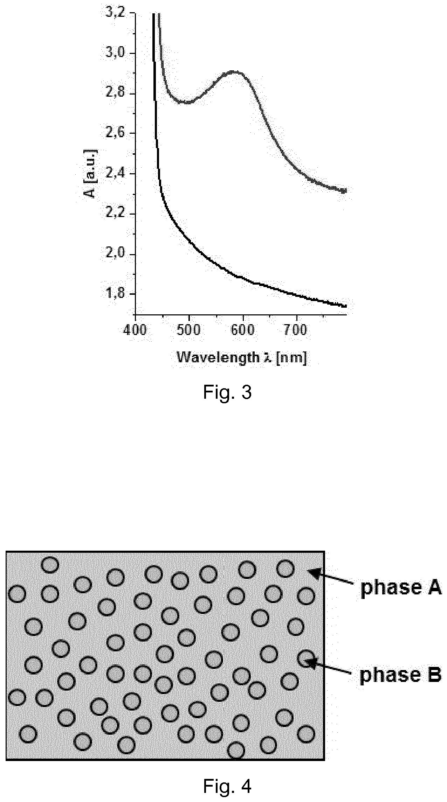

fig. 3 shows a graph of absorption A of radiation as a function of wavelength λ for Bi₂O₃ - Ag eutectic before and after annealing, where the maximum absorption after annealing in the range of 590 nm associated with the occurrence of LSPR in the obtained material is visible;
fig. 4 shows a schematic view of cross-section of an oxide-metal or oxide-semiconductor eutectic rod, where the metal or the semiconductor.

### Detailed Description

Preferred embodiments of the invention are described in details below. The examples serve only as an illustration and do not limit the scope of the present invention.

### Example 1.

In a ceramic mortar, components are triturated in suspension in propanol - 15.4 mole% of Ag having a melting point of 961.98°C and 84.6 mole% of Bi₂O₃ having a melting point of 817°C. Then, the obtained material is heated in a resistance furnace to a temperature of 100°C to evaporate propanol. Thus prepared material is placed in a crucible which is then mounted in a system for directional micro-pulling down from a melt. The main process for obtaining a rod is conducted in the temperature range of 650 - 700°C.

Then obtained eutectic rod is cut into plates having a thickness of about 1 mm which are then placed in the resistance furnace and are heat-treated in an oxidizing atmosphere. Annealing is carried out at a temperature of 600°C, for at least 4 hours. The plates are then polished on both sides below a thickness of 100 µm.

Plasmonic properties are examined by spectroscopic studies. Annealing causes dispersion of the metallic phase and creation of metallic nanoparticles. Such a structure in the metal-dielectric material gives rise to localised surface plasmon resonance LSPR for the wavelength of 590 nm.

The obtained metal-dielectric eutectic material having a melting point of 680°C meets the following requirements: it consists of two components, Ag and Bi₂O₃. B - Ag phase, constituting metallic precipitations, is a metal having a low electrical resistance 15.87 nΩm, having a negative actual value of electric permittivity, Re(eps) < 0: for the ranges of electromagnetic wavelengths λ 172 nm - 258 nm and from 326 nm. Imaginary value of electric permittivity, Im(eps) for the above ranges λ is respectively 1.79 to 3.6 F/m and from 0.579 F/m, increasing proportionally along with the wavelength. A - Bi₂O₃ phase, constituting a dielectric matrix, is a dielectric having a positive actual electric permittivity, Re(eps) > 0 for the same ranges of wavelengths λ. The size of metallic precipitations is about 5 nm.

## Claims

1. An eutectic material, in particular a metal-dielectric one, **characterised in that**, it consists of:
82.0 - 86.0 mole% of Bi₂O₃:
• constituting a dielectric matrix,
• having a positive actual electric permittivity, Re(eps) > 0 for the range of electromagnetic wavelengths λ UV/Vis/NIR,
and 14.0 - 18.0 mole% of Ag:
• constituting metallic precipitations of size not larger than 500 nm for use in the optical range,
• having a resistance of 15.87 nΩm,
• having a negative actual value of electric permittivity, Re(eps) < 0 for the range of electromagnetic wavelengths λ 172 nm - 258 nm and Re(eps) < 0 for the range of electromagnetic wavelengths λ from 326 nm to 2500nm,
• and of an imaginary value of electric permittivity Im(eps) for these ranges λ, respectively 1.79 - 3.6 F/m and from 0.579 F/m, proportionally increasing along with the wavelength λ.

2. The material according to claim 1, **characterised in that** it consists of 15.4 mole% of Ag of Re(esp) < 0, and 84.5 mole% of Bi₂O₃ of Re(esp) > 0.

## Patentansprüche

1. Ein eutektisches Material, insbesondere ein Metall-dielektrikum, **dadurch gekennzeichnet, dass** es aus Folgendem besteht:
82,0-86,0 Mol-% Bi₂O₃:
• eine dielektrische Matrix darstellt,
• mit einer positiven tatsächlichen elektrischen Permittivität, Re(eps)> 0 für den Bereich der elektromagnetischen Wellenlängen λ UVA/Vis/NIR,
und 14,0 bis 18,0 Mol-% Ag:
• Metallniederschläge mit einer Größe von nicht mehr als 500 nm zur Verwendung im optischen Bereich darstellt,
• mit einem Widerstand von 15,87 nΩm,
• mit einem negativen tatsächlichen Wert der elektrischen Permittivität, Re(eps)< 0 für den Bereich der elektromagnetischen Wellenlängen λ 172 nm - 258 nm und Re(eps)<0 für den Bereich der elektromagnetischen Wellenlängen λ von 326 nm bis 2500 nm,
• und mit einem imaginären Wert der elektrischen Permittivität Im(eps) für diese Bereiche, jeweils λ1,79-3,6 F/m und von 0,579 F/m, steigend proportional mit der Wellenlänge λ.

2. Material nach Anspruch 1, **dadurch gekennzeichnet, dass** es aus 15,4 Mol% Ag mit Re(esp)<0 und 84,5 Mol% Bi₂O₃ mit Re(esp)> 0 besteht.

## Revendications

1. Un matériau eutectique, en particulier un matériau métallique-diélectrique, **caractérisé en ce qu'**il est constitué de :
82,0 - 86,0% en moles de Bi₂O₃ :
• constituant une matrice diélectrique,
• ayant une permittivité électrique réelle positive, Re(eps) > 0 pour la gamme de longueurs d'ondes électromagnétiques λ UVA/is/NIR,
et 14,0 - 18,0% en moles d'Ag :
• constituant des précipitations métalliques dont la taille ne dépasse pas 500 nm pour utilisation dans la gamme optique,
• ayant une résistance de 15,87 nΩm,
• ayant une valeur réelle négative de la permittivité électrique, Re(eps) < 0 pour la gamme de longueurs d'ondes électromagnétiques λ 172 nm - 258 nm et Re(eps) < 0 pour la gamme de longueurs d'ondes électromagnétiques λ de 326 nm à 2500 nm,
• et d'une valeur imaginaire de la permittivité électrique Im(eps) pour ces gammes λ, respectivement 1,79 - 3,6 F/m et à partir de 0,579 F/m, augmentant proportionnellement avec la longueur d'onde λ.

2. Le matériau selon la revendication 1, **caractérisé en ce qu'**il est constitué de 15,4% en moles d'Ag de Re(esp) <0 et 84,5% en moles de Bi₂O₃ de Re(esp) > 0.
